Europäisches Patentamt

European Patent Office

Office européen des brevets

(19)

(11) EP 0 903 428 A2

(12) **EUROPÄISCHE PATENTANMELDUNG**

(43) Veröffentlichungstag:
24.03.1999 Patentblatt 1999/12

(51) Int. Cl.⁶: **C30B 15/26**, C30B 29/06

(21) Anmeldenummer: 98114783.8

(22) Anmeldetag: 06.08.1998

(84) Benannte Vertragsstaaten:
AT BE CH CY DE DK ES FI FR GB GR IE IT LI LU
MC NL PT SE
Benannte Erstreckungsstaaten:
AL LT LV MK RO SI

(30) Priorität: 03.09.1997 DE 19738438
21.04.1998 DE 19817709

(71) Anmelder: Leybold Systems GmbH
D-63450 Hanau am Main (DE)

(72) Erfinder:
• Altekrüger, Burkhard, Dr. Dipl.-Phys.
63755 Alzenau (DE)
• Aufreiter, Joachim, Ing.
63755 Alzenau (DE)
• Brüss, Dieter, Dipl.-Ing.
63486 Bruchköbel (DE)
• Kalkowski, Klaus, Dipl.-Ing.
63584 Gründau (DE)

(74) Vertreter:
Schickedanz, Willi, Dipl.-Ing.
Langener Strasse 68
63073 Offenbach (DE)

(54) **Einrichtung und Verfahren für die Bestimmung von Durchmessern eines Kristalls**

(57) Die Erfindung betrifft eine Einrichtung und ein Verfahren für die Bestimmung von Durchmessern eines Kristalls, der aus einer Schmelze gezogen wird. Es sind hierbei mehrere Videokameras vorgesehen, von denen jede einen eigenen Abschnitt entlang der vertikalen Achse des Kristalls oder in eine Richtung senkrecht hierzu abbildet. Die Bildwinkel der Kameras sind so ausgelegt, daß der abzubildende Gegenstand die gesamte Bildebene - wenigstens in einer Richtung - vollständig ausfüllt. Für Gegenstände mit kleinem Durchmesser - z. B. den Kristallhals - wird eine Kamera mit kleinem Bildwinkel verwendet, während für Gegenstände mit großem Durchmesser - z. B. den Kristall-Body - eine Kamera mit großem Bildwinkel verwendet wird.

EP 0 903 428 A2

**Beschreibung**

Die Erfindung betrifft eine Einrichtung und ein Verfahren nach den Oberbegriffen der Patentansprüche 1, 18 und 22.

Eine derartige Einrichtung wird beispielsweise für die Messung des Kristalldurchmessers beim Ziehen von Einkristallen nach dem Czochralski-Verfahren verwendet.

Auf dem Gebiet des Kristallzüchtens ist eine Vielzahl von unterschiedlichen Verfahren bekannt, z. B. das Kristallzüchten aus der Gasphase, aus der Lösung oder aus der Schmelze. Die verschiedenen Verfahren zum Kristallziehen aus der Schmelze haben wegen ihrer weit entwickelten Verfahrenstechnik und der Produktionsquantität eine Vorrangstellung gegenüber anderen Züchtungsmethoden erreicht. Die bekanntesten Verfahren beim Kristallzüchten aus der Schmelze sind das

Kyropoulus-Verfahren, das Bridgman-Verfahren und das Czochralski-Verfahren. Während beim Kyropoulus-Verfahren ein gekühlter Keimkristall in die Schmelze eingetaucht und beim Bridgman-Verfahren ein Tiegel vertikal im Temperaturgradienten gesenkt wird, wird beim Czochralski-Verfahren ein Kristall aus der Schmelze gezogen.

Beim Czochralski-Verfahren schmilzt das Ausgangsmaterial ähnlich wie beim Kyropoulus-Verfahren in einem Tiegel. Ein Keimkristall taucht in die Schmelze und wird von ihr benetzt und damit angeschmolzen. Anschließend wird der Keimkristall bei gleichzeitigem Absenken der Temperatur kontinuierlich nach oben aus der Schmelze gezogen. Kristall und Tiegel drehen sich hierbei gegenläufig. Die Ziehgeschwindigkeit und die Temperatur der Schmelze sind so geregelt, daß der Kristall nach Ausbildung einer Schulter mit konstantem Durchmesser wächst. Die Orientierung des wachsenden Kristalls entspricht der des Keimkristalls (vgl. hierzu Bonora: Czochralski Growth of Single-Crystal Silicon - A State-of-the-Art Overview, Microelectronic Manufacturing and Testing, September 1980, S. 44 bis 46).

Der Solldurchmesser der heute in der Produktion gezogenen Einkristalle richtet sich nach der in der Halbleitertechnik verarbeiteten Wafergröße, die aus wirtschaftlichen Gründen trotz fortschreitender Miniaturisierung der elektronischen Bauelemente immer größere Werte annimmt und heute überwiegend bei 150 bis 200 mm liegt. Es werden jedoch auch schon Scheiben von 300 mm bis 400 mm Durchmesser geplant. Bei diesen Ausmaßen für einen fehlerfreien Einkristall spielt neben der Kristallstruktur und der Reinheit vor allem die Durchmesser-Gleichmäßigkeit längs des zylinderförmigen Kristalls eine wichtige Rolle. Je glatter die Zylinderwand ist, um so weniger Bearbeitungsaufwand und Materialverlust sind zu erwarten. Aus diesem Grund ist die Durchmesserregelung während des Zielprozesses ein wichtiges Kriterium für die Wirtschaftlichkeit.

Die genaue Erfassung und Kontrolle des tatsächlichen aktuellen Kristalldurchmessers in allen Phasen des Züchtungsprozesses stößt indessen in der Praxis auf erhebliche Schwierigkeiten.

Um diese Schwierigkeiten zu überwinden, sind bereits mechanische, elektrische und optische Lösungen vorgeschlagen worden.

Bei einer mechanischen Lösung wird das Gewicht des Kristalls überwacht und von diesem Gewicht auf seinen Durchmesser rückgeschlossen (GB-PS 1 457 275). Hierbei wird ein Signal erzeugt, das der effektiven trägen Masse des Kristalls beim Herausziehen entspricht. Dieses Signal wird jeweils mit einem hochgerechneten Erwartungswert verglichen. Weichen beide Signale voneinander ab, wird aufgrund eines Regeleingriffs die Ziehgeschwindigkeit geändert, um den tatsächlichen Kristall-Durchmesser dem Soll-Durchmesser anzupassen. Nachteilig ist bei diesem Verfahren, daß es infolge des langsamen Kristallwachstums ungenau und verschiedenen Störeinflüssen unterworfen ist.

Bei einer Weiterentwicklung dieser Lösung wird ein Verfahren vorgeschlagen, mit dem die Wirkung des Wärmeverzugs bei der Kristallbildung kompensiert wird (DE-OS 25 13 924).

Eine weitere bekannte, auf mechanischen Prinzipien beruhende Lösung des Problems der Durchmesser-Messung eines Kristalls, der aus der Schmelze gezogen wird, besteht darin, daß das aufgrund einer relativen Drehbewegung zwischen Kristall und Schmelze auftretende Drehmoment als Maß für die Bestimmung des Durchmessers des Kristalls herangezogen wird (DE-OS 36 40 868).

Die Messung des Durchmessers von Kristallen mit Hilfe elektrischer Methoden ist ebenfalls bereits bekannt (DD-PS 145 407). Hierbei wird der elektrische Widerstand des wachsenden Kristalls beim Fließen einer Gleich- oder Wechselspannung durch den Kristall oder durch das System heizbarer Tiegel, Schmelze, Kristall, Ziehgestänge gemessen. Zur Messung des elektrischen Widerstands des Kristalls befindet sich auf der Oberfläche der Schmelze ein schwimmender Kontakt, der durch seine Materialspezifik und konstruktiven Besonderheiten keine Reaktion mit der Schmelze und keine Beeinflussung der thermischen Bedingungen an der Grenzfläche Schmelze-Kristall bewirkt.

Bei einem anderen bekannten Verfahren zum Ziehen von Einkristallstäben gleichförmigen Durchmessers aus einer in einem Tiegel enthaltenen Schmelze werden optische Mittel zur Messung des Kristalldurchmessers verwendet (DE-PS 16 19 967). Hierbei werden die Änderungen des Stabdurchmessers mittels eines aus mechanischen Stellgliedern und einem oder mehreren auf die von der Schmelze ausgesandte Strahlung eingestellten Strahlungsdetektoren bestehenden Regelsystems ständig ausgeglichen. Die Strahlungsdetektoren werden so eingestellt, daß sie die von einem kleinen Oberflächenbereich der Schmelze in unmittelbarer Nähe des wachsenden Kristalls erzeugte Strahlungsenergie im nahen infraroten und im sichtbaren Spektralbereich erfassen und ihre Sichtlinie und die Kristallachse einen spitzen Winkel bilden.

Es ist auch ein optisches Verfahren zur Messung des Durchmessers eines durch Zonenschmelzen erzeugten Halbleiterstabs bekannt, bei welchem der Stab im Bereich der Schmelzzone von einer Fernsehkamera aufgenommen wird, die Kamerasignale durch Vergleich mit einem veränderlichen Schwellwert in ein binäres Videosignal umgewandelt werden und der Durchmesser des Stabs an der Stelle gemessen wird, an der ein in axialer Richtung auftretender, die Fest-Flüssig-Grenze kennzeichnender Helligkeitssprung festgestellt wird (Zeitschrift "Journal of Crystal Growth", 13/14, 1972, S. 619 - 623).

Bei einer Verbesserung dieses Verfahrens wird der Ort des Phasenübergangs zwischen Schmelze und herauswachsendem Halbleiterkristall noch genauer bestimmt, indem mehrere Bilder bei verschiedenen Schwellwerten aufgenommen und die bei den verschiedenen Schwellwerten gewonnenen binären Videosignale darauf untersucht werden, ob eine sich über den Stabquerschnitt ausdehnende Zone von einer vorgegebenen minimalen Breite vorhanden ist, die dunkler ist als ein benachbarter Startbereich (DE-OS 33 25 003).

Die korrekte Erfassung des tatsächlichen Durchmessers eines Kristalls auf optischem Weg unterliegt während des Züchtungsprozesses indessen den verschiedensten Störeinflüssen, welche die Meßergebnisse so verfälschen können, daß eine korrekte Prozeßführung nicht mehr möglich ist. Dadurch können Qualität und Ausbeute des Züchtungsprozesses stark beeinträchtigt werden. Zu diesen Störeinflüssen gehören unter anderem stark wechselnde Helligkeits- und Kontrastverhältnisse an den Meßobjekten, d. h. am Kristall, an der Schmelze oder an dem hell-leuchtenden Meniskusring um den Kristall, sowie störende Reflexionen auf der Schmelze oder die Unruhe der Meßobjekte aufgrund mechanischer Störungen.

Außerdem kann die geometrische Form des gerichteteten Kristalls zum Teil erheblich von der Idealform eines Zylinders mit kreisförmigem Querschnitt abweichen. Durch Schwankungen des Kristalldurchmessers kann die Sichtbarkeit auf den vollen Kristalldurchmesser und den zugehörigen hell-leuchtenden Meniskus-Ring erheblich eingeschränkt sein. Des weiteren können Einbauten und Vorrichtungen zur Optimierung der Temperaturverteilung die Sichtbarkeit des Kristalls einschränken und weiter behindern.

Bereits bei den derzeit üblichen Kristalldurchmessern von etwa 150 mm bis 200 mm können diese Probleme bei der Erfassung und Kontrolle des Kristalldurchmessers zu erheblichen Beeinträchtigungen des Züchtungsprozesses führen. Für die künftige Generation der 300 mm- und 400 mm-Kristalle wird sich das Problem einer zuverlässigen Kontrolle des Kristalldurchmessers noch weiter verschärfen.

Es ist auch noch ein optisches System bzw. ein Verfahren zum Regeln des Wachstums eines Siliziumkristalls bekannt, mit dem die vorstehenden Probleme gelöst werden sollen und bei dem mit Hilfe einer Fernsehkamera der Durchmesser des Siliziumkristalls gemessen wird, der aus einer Siliziumschmelze gezogen wird, wobei die Oberfläche dieser Schmelze einen Meniskus aufweist, der als heller Bereich in der Nähe des Siliziumkristalls sichtbar ist (EP 0 745 830 A2). Bei diesem System wird zunächst ein Bildmuster eines Teils des hellen Bereichs in der Nähe des Siliziumkristalls mittels der Kamera abgebildet. Sodann werden die Charakteristika des Bildmusters detektiert. Als Charakteristika eines Bildmusters gilt beispielsweise der Intensitätsgradient. Hierauf wird eine Kante des hellen Bereichs als Funktion der detektierten Charakteristika definiert. Sodann wird eine Kontur, welche die definierte Kante des hellen Bereichs einschließt, definiert und schließlich wird der Durchmesser der definierten Kontur ermittelt, wobei der Durchmesser des Siliziumkristalls als Funktion des ermittelten Durchmessers der definierten Kontur ermittelt wird.

Nachteilig ist bei diesem bekannten System, daß die Genauigkeit bei einigen Anwendungsfällen noch nicht hoch genug ist und insbesondere äußere Störeinflüsse nicht hinreichend berücksichtigt werden.

Des weiteren sind eine Vorrichtung und ein Verfahren zum Ziehen von Einkristallen nach dem Czochralski-Verfahren bekannt, bei denen über eine Auswerteschaltung der Durchmesser eines Kristalls ermittelt wird (DE 195 48 845 A1). Hierbei sind zwei Kameras vorgesehen, deren jeweilige Bildachsen einen Winkel von 90 Grad bilden. Mit diesen Kameras werden verschiedene Punkte auf ein und demselben Objekt, z. B. einem Meniskusring, erfaßt. Die Brennweite bzw. der Bildwinkel dieser Kameras sind identisch, wodurch es nicht möglich ist, verschieden große Bereiche eines Objekts so auf der Bildebene der Kamera abzubilden, daß wenigstens eine Koordinate voll ausgefüllt ist.

Schließlich ist auch noch ein Übergangsstellen-Winkel-Erkennungssystem bekannt, bei dem auch zwei Kameras eingesetzt werden können, deren Bildachsen einen Winkel in einer vertikalen Ebene eines Kristalls bilden (US-PS 4 943 160, Fig. 4). Unter Übergangsstellen-Winkel wird dabei der Winkel verstanden, der die Meniskus-Oberfläche mit der vertikalen Achse eines Kristalls bildet bzw. mit einer Achse parallel zu dieser vertikalen Kristall-Achse. Andere Bereiche des Kristalls werden durch die Kameras nicht erfaßt. Die Kameras besitzen auch keine Brennweite bzw. keinen Bildwinkel, die an die Durchmesser verschiedener Kristallteile angepaßt sind.

Der Erfindung liegt die Aufgabe zugrunde, den Durchmesser eines Kristalls mit Hilfe eines optischen Erfassungssystems mit hoher Präzision zu erfassen.

Diese Aufgabe wird mit den Merkmalen der Patentansprüche 1, 18, und 22 gelöst.

Der mit der Erfindung erzielte Vorteil besteht insbesondere darin, daß durch den Einsatz von mindestens zwei Kameras die Kameraauflösung an das jeweilige Meßproblem angepaßt werden kann. Bei großen Kristalldurchmessern kann z. B. die Auflösung durch zwei Kameras, die ein zusammengesetztes Bild ermöglichen, verdoppelt werden. Außerdem können die Probleme, die aufgrund unterschiedlicher Lichtstärke- und Kontrastverhältnisse auftreten, eliminiert werden. Durch die Berücksichtigung verschiedener Relevanz-Bedingungen für gültige Messungen wird überdies ein stabiles Signal und damit eine verbesserte Prozeßführung erreicht. Hinzu kommt, daß eine automatische Absolutwert-Eichung möglich ist und auch bei solchen Phasen des Prozesses, in denen kein Meniskus auftritt, der Durchmesser des Kristalls gemessen werden kann.

Ein Ausführungsbeispiel der Erfindung ist in den Zeichnungen dargestellt und wird im folgenden näher beschrieben. Es zeigen:

Fig. 1          eine Kristallzieh-Vorrichtung mit zwei einander gegenüberliegenden Kameras;

Fig. 2          eine Kristallzieh-Vorrichtung mit zwei nebeneinander angeordneten Kameras;

Fig. 3          eine Kristallzieh-Vorrichtung während des Kamera-Kalibrierungsvorgangs;

Fig. 4          eine vergrößerte Darstellung eines aus einer Schmelze gezogenen Kristalls;

Fig. 5a bis 5d    schematische Darstellungen des Kristallwachstums;

Fig. 6          einen Kristall und einen Impfling, die von drei Kameras erfaßt werden;

Fig. 7          eine perspektivische Ansicht eines Kristalls zur Erläuterung eines Verfahrens zum Ermitteln des Kristalldurchmessers;

Fig. 8          ein Flußdiagramm zu dem Verfahren zur Ermittlung des Durchmessers des Kristalls;

Fig. 9          eine schematische Ansicht von oben auf zwei Kameras und einen Kristall;

Fig. 10         eine schematische Ansicht von oben auf drei Kameras und einen Kristall;

Fig. 11         einen Teil eines Flußdiagramms bei Einsatz von zwei Kameras.

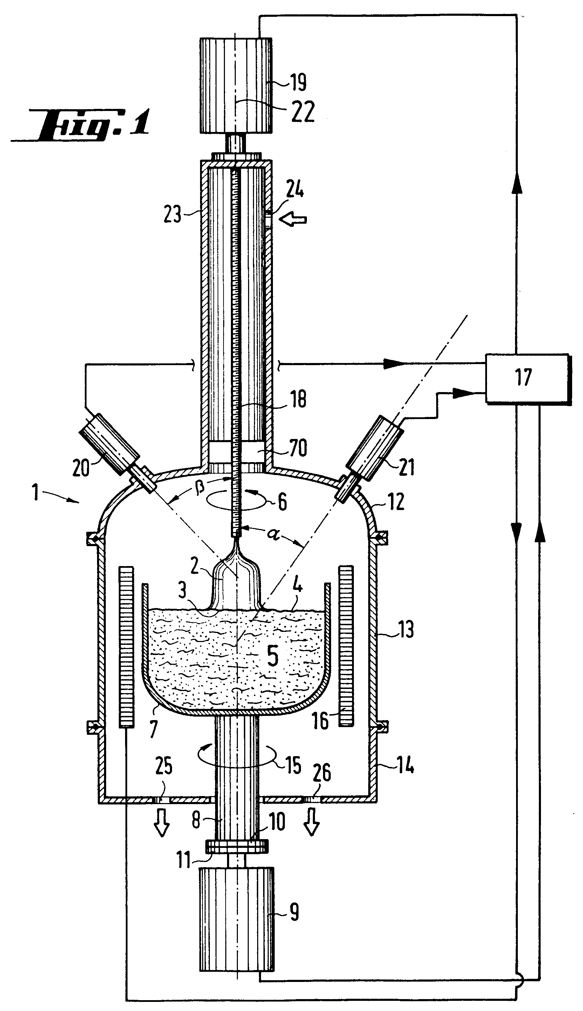

In der Fig. 1 ist eine Vorrichtung 1 dargestellt, mit der es möglich ist, den Durchmesser eines Kristalls 2 auf optischem Weg zu bestimmen. Die Unterseite 3 des Kristalls 2 ruht hierbei auf der Oberfläche 4 einer Schmelze 5, wobei der Kristall im Sinne des Pfeils 6 gedreht wird. Die Schmelze 5 befindet sich in einem Tiegel 7, der mittels einer Welle 8 von einem Elektromotor 9 angetrieben wird. Welle 8 und Motor 9 sind über Flansche 10, 11 miteinander verbunden. Der Tiegel 7 befindet sich in einem Gehäuse, das aus einem oberen Teil 12, einem mittleren Teil 13 und einem unteren Teil 14 besteht, und ist im Sinne des Pfeils 15 drehbar. Um den Tiegel 7 herum ist eine elektrische Heizeinrichtung 16 angeordnet, die aus einer Einrichtung 17 mit elektrischer Energie versorgt wird.

Die Drehung des Kristalls 2 erfolgt mittels einer Stange 18, z. B. einer Gewindestange, die von einem Elektromotor 19 angetrieben wird. Dieser Motor wird ebenfalls aus der Einrichtung 17 mit elektrischer Energie versorgt.

Im oberen Teil 12 des Gehäuses sind zwei Kameras 20, 21 angeordnet, deren Längsachsen zur vertikalen Achse 22 der Stange 18 und des Tiegels 7 einen Winkel α bzw. β bilden.

Der obere Teil 12 des Gehäuses steht mit einem Rohr 23 in Verbindung, das die Stange 18 umgibt und eine Gaseinlaßöffnung 24 aufweist. Im Bodenteil 14 des Gehäuses sind Gasauslaßöffnungen 25, 26 vorgesehen, Die Stange 18 kann mittels des Elektromotors 19 nicht nur gedreht, sondern auch angehoben werden. Die Steuerung der Elektromotoren 9, 19 erfolgt über die Einrichtung 17, welche Informationen von den Kameras 20, 21 erhält und diese auswertet.

Hinter dem Rohr 22 oder an einer anderen Stelle kann sich eine dritte Kamera befinden, die in der Fig. 1 nicht sichtbar ist.

Die Kameras 20, 21 weisen feste Brennweiten bzw. Bildwinkel auf und bilden einen bestimmten Bereich des Kristalls - Hals, Body oder dergleichen - ab. Dabei ist sichergestellt, daß der abgebildete Gegenstand die Bildebene wenigstens in einer Koordinate vollständig ausfüllt, um eine optimale Auflösung zu erhalten. Da der Abstand des Objektivs der Kamera vom abzubildenden Gegenstand bekannt ist, kann die Brennweite so ausgewählt werden, daß die optimalen Bedingungen vorliegen. Unter Bildebene wird hierbei die Ebene einer Kamera verstanden, in welcher ein Bild abgebildet wird, also bei herkömmlichen Kleinbildkameras die 24 x 36 Filmebene bzw. bei elektronischen Kameras die Oberfläche des lichtempfindlichen Chips.

Sind die Kameras starr in den Gehäusedeckel 12 integriert, handelt es sich bei den Objektiven vorzugsweise um solche mit Festbrennweite, weil der Abstand zwischen Kamera und Objekt konstant ist. Es ist jedoch auch möglich, z. B. diejenige Kamera, die den Hals des Kristalls beobachten soll, der sich mit dem wachsenden Kristall nach oben bewegt, im Gehäusedeckel 12 schwenkbar auszubilden und mit einem Zoom-Objektiv zu versehen, das automatisch so gesteuert wird, daß die Bildebene der Kamera stets optimal durch das abgebildete Objekt ausgenutzt wird. Der sich ändernde Abstand zwischen Objektiv und Objekt wird somit durch die sich ändernde Brennweite berücksichtigt.

Mit Hilfe der Kameras werden die jeweiligen Durchmesser der Kristallbereiche ermittelt und mit entsprechenden Sollwerten verglichen. Die Differenz zwischen Ist- und Sollwert kann dann zu einer Veränderung der Kristallziehbedingungen herangezogen werden.

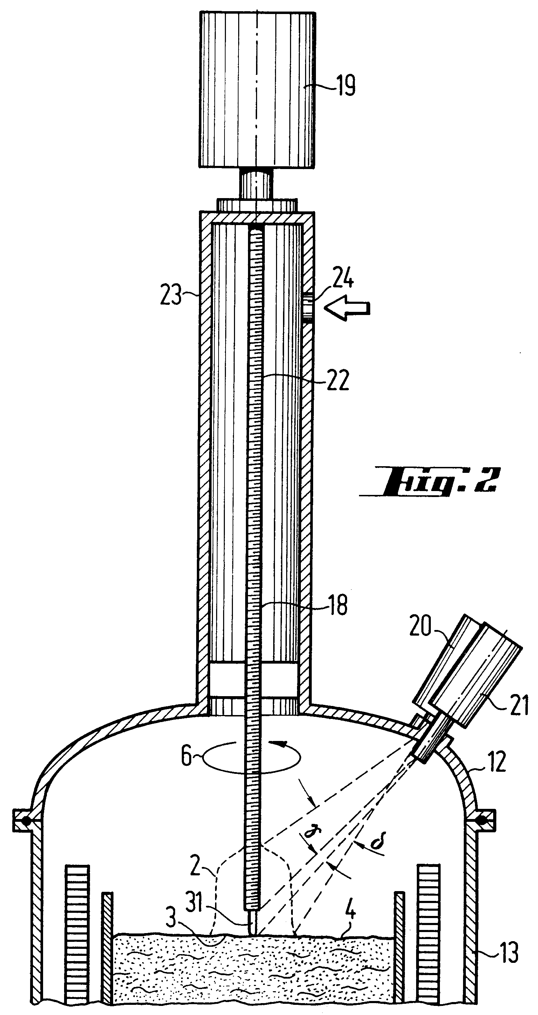

In der Fig. 2 ist der obere Teil der in der Fig. 1 gezeigten Vorrichtung noch einmal dargestellt, wobei jedoch die beiden Kameras 20, 21 nebeneinander angeordnet sind. Die Stange 18 ist hierbei nach unten gefahren - es handelt sich um den Beginn des Ziehprozesses - und weist einen Impfkristall 31 auf. Die Kamera 21, die eine Festbrennweite hat, ist auf diesen Impfkristall 31 ausgerichtet, d. h. ihr Bildwinkel ist $\gamma$. Hierdurch kann der Impfkristall so abgebildet werden, daß er die komplette Bildebene der Kamera ausfüllt. Dies wiederum erlaubt es, die Konturen und anderen Eigenschaften des Impfkristalls 31 genau zu untersuchen.

Die zweite Kamera 20 hat ein Objektiv mit einer anderen Festbrennweite und erfaßt den größeren Kristall 2, der in der Fig. 2 gestrichelt dargestellt ist, über den Bildwinkel $\delta$. Somit kann auch der größere Kristall 2 derart abgebildet werden, daß er die ganze Bildebene der Kamera 20 ausfüllt.

Durch die Verwendung von zwei Kameras 20, 21 kann folglich der Kristall in allen seinen Wachstumsphasen vollständig überwacht werden. Die Kameras 20, 21 können gleichzeitig verwendet werden, vorzugsweise werden sie jedoch nacheinander zum Einsatz gebracht, wobei die Umschaltung von einer Kamera zur anderen automatisch durch eine Steuerung erfolgt. Es versteht sich, daß die sukzessive Verwendung der beiden Kameras innerhalb desselben Kristallziehprozesses erfolgt.

Die Verwendung von nur einer Kamera mit einem Zoom-Objektiv, die als solche bereits bekannt ist (japanische Patentanmeldung Sho 62-87482 vom 9. Oktober 1985), wäre bei Einsatz eines Auswertealgorithmus nachteilig und nicht mit zwei Kameras mit jeweiligem Fix-Fokus vergleichbar. Bei einer Fix-Fokus-Kamera kann der Bildwinkel so ausgelegt werden, daß das ganze aufzunehmende Objekt die Filmebene vollständig ausfüllt. Bei einer Zoom-Kamera werden dagegen nur Teile der Filmebene von dem Objekt bedeckt. Ist das Zoom-Objektiv beispielsweise auf Tele eingestellt und füllt dabei der Impfkristall 31 die ganze Filmebene aus, so bedeckt dieser Impfkristall bei einer Weitwinkeleinstellung nur einen Teil der Filmebene. Zwar bedeckt der Gesamtkristall 2 bei einer Weitwinkeleinstellung möglicherweise die ganze Filmebene, doch ändert dies nichts daran, daß der Impfkristall 31 nur einen kleinen Teil der Filmebene einnimmt und deshalb weniger genau untersucht werden kann. Mit zwei Fix-Fokus-Kameras unterschiedlicher Brennweite können dagegen gleichzeitig oder nacheinander, jedenfalls innerhalb eines einheitlichen Prozesses, zwei verschiedene Bereiche eines Kristalls abgebildet und ausgewertet werden. Die Verwendung von zwei Zoom-Kameras anstelle von zwei Fix-Fokus-Kameras wäre zwar denkbar, doch würden sich dann Probleme bei der Kalibrierung ergeben, weil diese eine 100 % exakte Fokussierung erfordert.

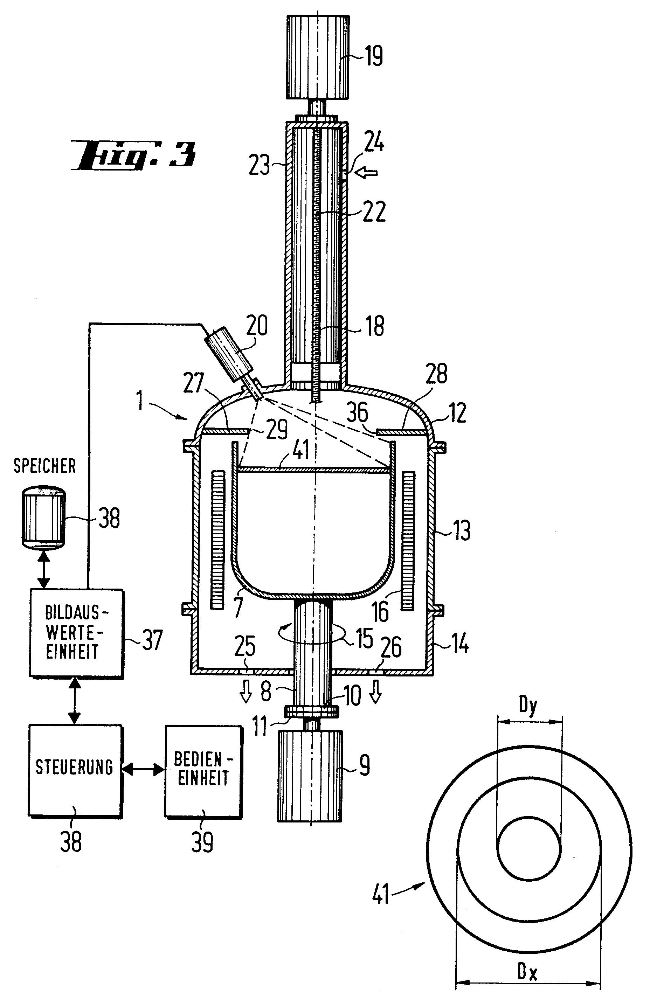

In der Fig. 3 ist dargestellt, wie eine solche Kalibrierung erfolgen kann. Der Einfachheit halber ist nur eine Kamera 20 dargestellt; es versteht sich jedoch, daß die Kalibrierung einer zweiten und dritten Kamera auf entsprechende Weise erfolgen kann.

Für die Kalibrierung sind in der Fig. 3 zwei Varianten dargestellt. Bei der ersten Variante sind zwei Begrenzungen 27, 28 vorgesehen, die auch Teile eines umlaufenden Rings sein können. Die Kanten 29, 36 dieser Begrenzungen dienen als Markierungen für die Soll-Positionen. Sie werden von der Kamera aufgenommen und anschließend in einer Bildauswerteeinheit 37 ausgewertet. Diese Bildauswerteeinheit 37 ist mit einem Massenspeicher 38 zum Speichern von Kalibrierdaten verbunden. Die Informationen der Bildauswerteeinheit 37 werden einer Steuerung 38 zugeführt, die auch mit Daten einer Bedieneinheit 39 beaufschlagt werden kann.

Statt der Begrenzungen 27, 28 kann bei einer zweiten Variante auch in der Höhe der zu erwartenden Oberfläche der Schmelze eine Platte 41 angeordnet werden, die mit besonderen Kalibrierungs-Markierungen versehen ist. Diese Platte 41 kann auf ihrer Oberfläche mit einem Referenzbilder versehen sein, der verschiedene "Referenz-Durchmesser" $D_x$, $D_y$ enthält. Diese Referenz-Durchmesser können erfaßt, im Speicher 38 abgelegt und später verarbeitet werden. Da der Kalibrierungsvorgang in der Regel vor dem eigentlichen Kristallziehprozeß stattfindet, können die Begrenzungen 27, 28 bzw. die Platte 41 nach der Kalibrierung wieder abgebaut werden.

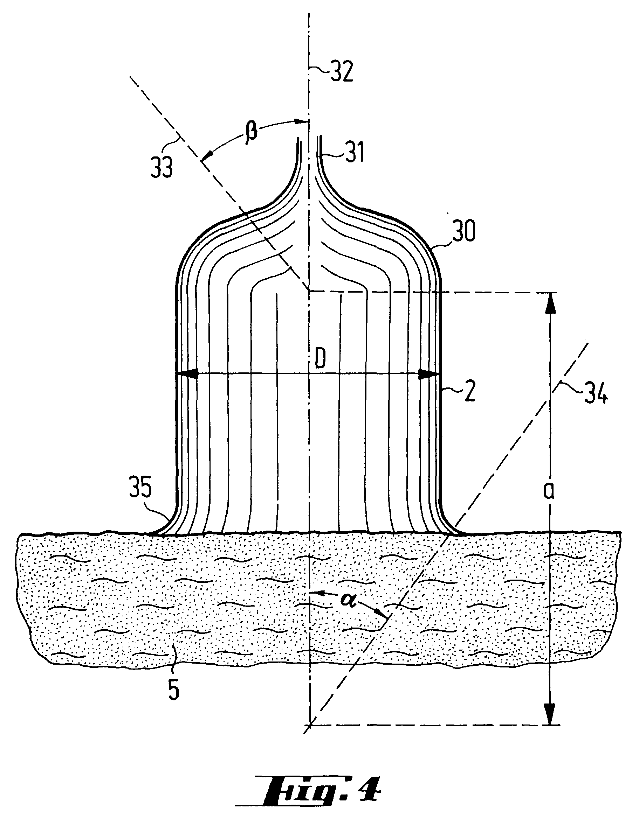

In der Fig. 4 ist eine vergrößerte Darstellung des Kristalls 2 gemäß Fig. 1 gezeigt, der aus der Schmelze 5 gebildet wird. Dieser Kristall hat eine im wesentlichen zylindrische Form und weist im oberen Bereich eine Schulter 30 auf, die in einen dünnen Hals 31 übergeht. Dieser Hals 31 entspricht dem Impfkristall oder Keim 31 (Fig. 2), mit dem der Kristallbildungsprozeß initiiert wird. Die vertikale Achse des Kristalls ist mit 32 bezeichnet, während die Längsachsen der in Fig. 4 nicht dargestellten Kameras 20, 21 gemäß Fig. 1 mit 33 bzw. 34 bezeichnet sind. Die Anordnung der Kameras bzw. ihrer Achsen ist in den Fig. 1 und 4 in ihrer allgemeinsten Form dargestellt. In der Praxis wird man sich jedoch in der Regel am Meniskus ausrichten, so daß die Achsen 33 und 34 sich in dem Punkt schneiden, der auch der Schnittpunkt zwischen der Oberfläche der Schmelze 5 und der Achse 32 ist. Derartige Anordnungen werden weiter unten noch im einzelnen beschrieben. Der Durchmesser D des Kristalls 2 kann, in Abhängigkeit von der Höhe, schwanken, obgleich der Kristall im wesentlichen die Form eines Zylinders hat. Der untere Bereich des Kristalls 2, der zwischen dem zylindrischen Teil und der Schmelze 5 liegt, wird als Meniskus 35 bezeichnet. Der Meniskus 35 ist gewissermaßen das Bindeglied zwischen Kristall 2 und Schmelze 5. Er stellt eine enge ringförmige Zone zwischen erstarrtem Kristall und flüssiger Schmelze dar, die deutlich heller leuchtet als die Schmelze selbst. Der Kristall scheint an der Grenzfläche Kristall - Schmelze von einem hellen Ring umgeben. Das optisch nicht ganz einfach zu erklärende Phänomen entsteht durch Reflexion der hauptsächlich von der Tiegelwand ausgehenden Strahlung an dem konkav gewölbten Übergang zwischen Schmelze und Kristall, so daß ein von oben auf Schmelze und Kristall blickender Beobachter einen dunkleren Kristall sieht, der in der Höhe der Schmelze von einem helleren Leuchtring umfaßt wird. Im Laufe des Ziehvorgangs verbreitert sich der Ring mit Absenken der Schmelze im Tiegel und Herauswachsen des entstehenden Kristalls etwa um das 3-fache. Dies macht es gegen Ende des Ziehvorgangs zunehmend schwerer, den Durchmesser durch Abbildung des Leuchtrings auf einem geeigneten Sensor exakt zu bestimmen.

Sind die Kameras 33, 34 ortsfest eingebaut, kann z. B. die Kamera 34 während eines ersten Zeitabschnitts des Kristallziehprozesses eingeschaltet sein. Zu Beginn eines zweiten Zeitabschnitts wird dann die Kamera 33 eingeschaltet. Bei einer solchen Betriebsweise handelt es sich um die oben erwähnte sukzessive Betriebsweise.

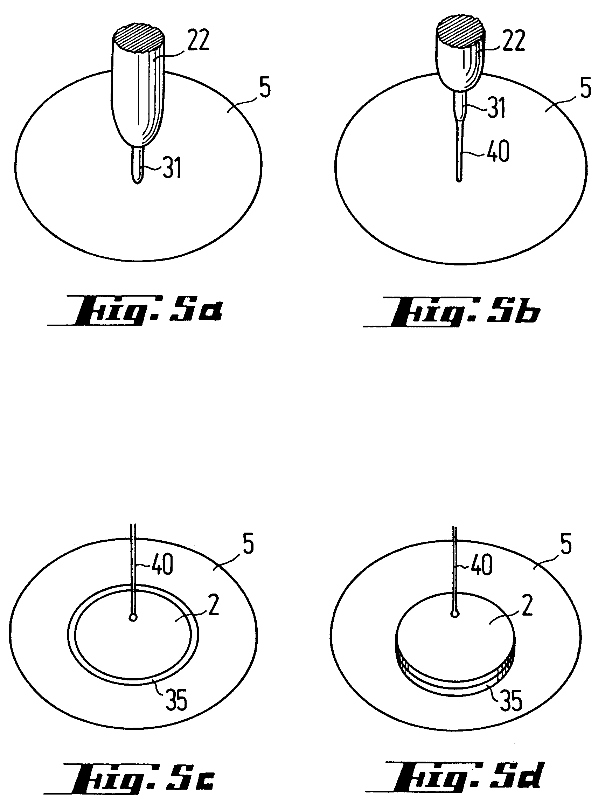

In den Fig. 5a bis 5d sind vier Ansichten eines wachsenden Kristalls aus der Sicht einer schräg oberhalb des Kristalls angeordneten Kamera dargestellt. Man erkennt hierbei nur die wesentlichen Elemente, d. h. Schmelze, Stange 22, Impfkristall 31, den Kristall 2 selbst und den Meniskus 35. Der Tiegel 7 ist weggelassen.

Fig. 5a zeigt den Beginn der Kristallbildung, wenn die Schmelze 5 mit dem Impfkristall 31 in Berührung kommt, der mit der Stange 22 in Verbindung steht. Wird die Stange 22 nun angehoben, ergibt sich der in der Fig. 5b dargestellte Zustand: Es bildet sich zunächst ein schlankes zylindrisches Gebilde 40 am Impfkristall, das mit der Schmelze 5 in Berührung steht. Wird die Stange 22 jedoch weiter angehoben, verlängert sich das Gebilde 40 und es bildet sich an seinem Ende ein Kristall 2 mit kreisförmigem Umfang, der von einem hell strahlenden Meniskus 35 umgeben ist. Dieser Zustand ist in Fig. 5c dargestellt. Bei weiterem Hochziehen der Stange 22 wächst der zylindrische Kristall 2 immer weiter aus der Schmelze 5 heraus. Bei einer schrägen Draufsicht einer Kamera ist nun der Meniskus 35 in seinem hinteren Bereich nicht mehr erkennbar; es ist lediglich noch der vordere Teilbogen von ihm sichtbar.

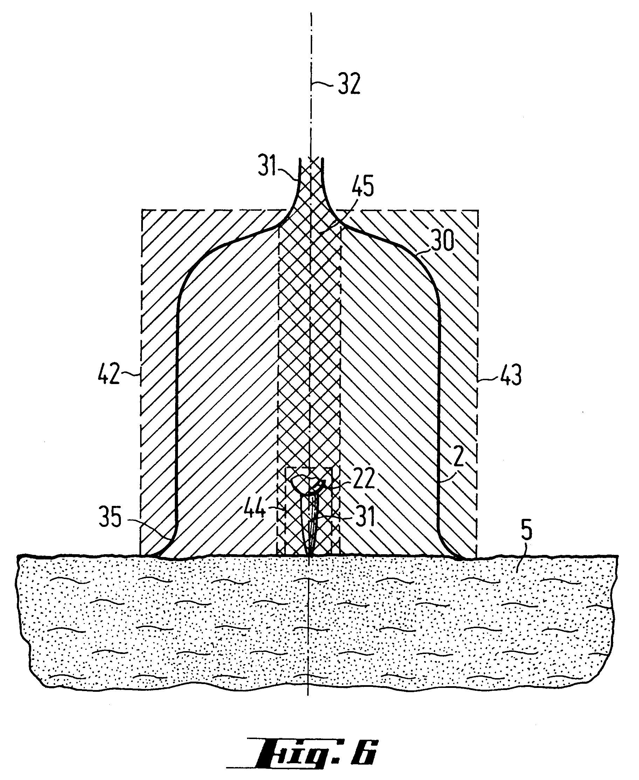

In der Fig. 6 ist noch einmal der Kristall 2 dargestellt, der jedoch jetzt nicht von zwei, sondern von drei nicht dargestellten Kameras erfaßt wird. Die erste Kamera erfaßt lediglich die linke Hälfte des Kristalls und bildet den mit einem schraffierten Rechteck 42 umrahmten Teil ab. Dagegen erfaßt die zweite Kamera die rechte Hälfte des Kristalls und bildet den mit einem schraffierten Rechteck 43 umrahmten Teil des Kristalls 2 ab.

Die dritte Kamera ist für die Abbildung des Impfkristalls 31 zuständig, was durch das Rechteck 44 symbolisiert ist. Die Abbildungen der beiden ersten Kameras können sich in einem Grenzbereich 45 auch überlappen. Durch die Verwendung zweier Kameras für die Abbildung des Kristalls kann die Auflösung erhöht werden, weil die gesamte Filmebene einer Kamera mit nur einer Hälfte des Kristalls statt mit dem ganzen Kristall ausgefüllt ist. Der Parallelbetrieb der beiden Kameras bezieht sich somit auf eine Richtung senkrecht zur Längsachse des Kristalls.

Bei der Erfindung ist somit ein serieller Betrieb möglich, bei dem die Kameras verschiedene Bereich des Kristalls entlang der vertikalen Achse des Kristalls auf der Abbildungsebene derart abbilden, daß der jeweils abgebildete Gegenstand die Abbildungsebene der Kamera wenigstens in eine Richtung, x- oder y-Richtung, ausfüllt, wobei die Kameras zeitlich nacheinander aktiviert werden. Es ist aber auch ein paralleler Betrieb möglich, bei dem die Kameras verschiedene Bereiche des Kristalls entlang einer Geraden, die senkrecht zur vertikalen Achse des Kristalls verläuft, auf der Abbildungsebene derart abbilden, daß die jeweils abgebildeten Gegenstände die Abbildungsebenen der Kameras wenigstens in eine Richtung ausfüllen, wobei die Kameras zeitlich gleichzeitig aktiviert sind.

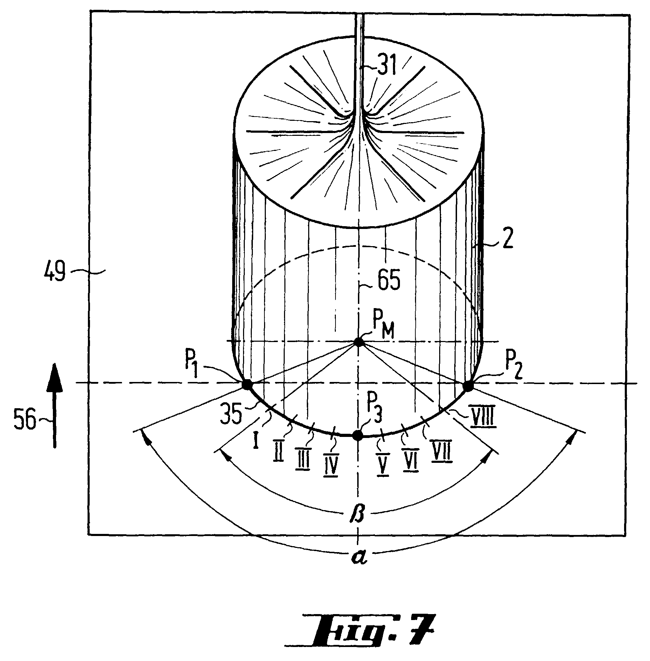

Fig. 7 zeigt den Kristall 2 in der Abbildung einer Kamera. Anhand dieser Abbildung wird im folgenden beschrieben, wie der Durchmesser des Kristalls 2 im einzelnen ermittelt wird. Der Rahmen 49 kann mit einem CCD-Chip gleichgesetzt werden, auf dem der Kristall 2 abgebildet ist. Der Chip wird nun Zeile für Zeile in Richtung des Pfeils 56 abgetastet. Dabei werden die Helligkeiten und/oder Helligkeitsgradienten der einzelnen Bereiche innerhalb des Rahmens 49 erfaßt. Ziel ist es, zunächst die Punkte $P_1$ und $P_2$ zu ermitteln, die den sichtbaren Teil des Meniskus begrenzen. Diese Punkte $P_1$ und $P_2$ sind dann aufgefunden, wenn an zwei Stellen einer Abtastzeile ein Helligkeitssprung stattfindet. Indem der Abstand zwischen $P_1$ und $P_2$ errechnet wird, erhält man den Quasi-Durchmesser des Kristalls. Um den wahren Durchmesser handelt es sich deshalb nicht, weil die Abbildung der Fig. 7 perspektivisch verzerrt ist. Es ist jedoch möglich, den wahren Wert dadurch zu ermitteln, daß ein Vergleich mit einer Strecke $P_1$ - $P_2$ aus der Kalibrierung vorgenommen wird. Der verzerrten Strecke $P_1$ - $P_2$ kann also eine unverzerrte Strecke $P_1'$ - $P_2'$ zugeordnet werden, so daß man hierüber den wahren Durchmesser $P_1'$ - $P_2'$ kennt.

Dieser Durchmesser kann jetzt mit einem Maximaldurchmesser verglichen werden. Nur dann, wenn der neu ermittelte Durchmesser größer ist als der abgespeicherte Maximaldurchmesser, wird der neue Durchmesser abgespeichert.

In einem nächsten Schritt wird festgestellt, ob die Punkte $P_1$ und $P_2$ symmetrisch zur Mittellinie 65 liegen. Ist dies der Fall, wird der Abstand der Verbindungslinie zwischen $P_1$ und $P_2$ zur unteren Kante kleiner, als der halbe Abstand zwischen $P_1$ und $P_2$ ist. Ist dies der Fall, handelt es sich bei dem gemessenen Durchmesser $P_1$ - $P_2$ um den maximalen Durchmesser.

Jetzt wird der Punkt $P_3$ bestimmt. Hierbei läuft der Abtaststrahl Zeile für Zeile von unten nach oben. Tritt auf einer Zeile nur ein Helligkeitssprung auf, dann handelt es sich um den Punkt $P_3$. Da jetzt alle drei Kreispunkte bekannt sind, können der Kreis und sein Mittelpunkt $P_M$ bestimmt werden. In einem nächsten Schritt wird der Winkel $\alpha$ bestimmt, der sich ergibt, wenn vom Mittelpunkt $P_M$ Geraden durch die Punkte $P_1$ und $P_2$ gezogen werden.

Dieser Winkel $\alpha$ wird zur Sicherheit um einen Winkel $\gamma$ reduziert, so daß gilt

$$\beta = \alpha - \gamma$$

Jetzt wird eine vorgegebene Anzahl Meßpunkte I - VIII gleichmäßig auf dem durch den neuen Winkel $\beta$ definierten Kreisbogen verteilt, und es wird aus diesen Meßpunkten der "Best-Fit-Kreis" bestimmt.

Die Meßpunkte I bis VIII müssen gleichmäßig über den sichtbaren Kreisbogen verteilt werden, nicht über einen errechneten, denn bei $\alpha$ handelt es sich um den sichtbaren Kreisbogen. Die Reduktion des Winkels $\alpha$ um $\gamma$ erfolgt deshalb, um die Meßpunkte I und VIII an den Rändern sicher erfassen zu können.

Durch eine möglichst große Anzahl von Meßpunkten soll eine hohe Genauigkeit bzw. eine hohe Auflösung für das Durchmessersignal erreicht werden. Es wird gewissermaßen eine Ausgleichskurve durch eine Vielzahl von Meßpunkten gelegt.

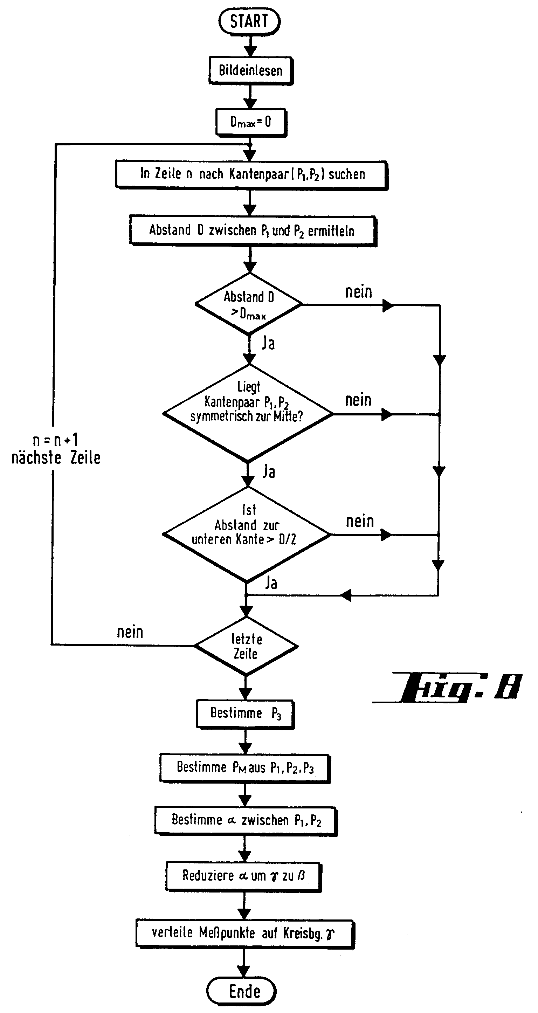

Fig. 8 zeigt ein Flußdiagramm zu dem Verfahren zur Ermittlung des Durchmessers des Kristalls. Wie man hieraus erkennt, wird zunächst das von einer Kamera aufgenommene Bild eingelesen. Dieses Bild entspricht etwa dem in der Fig. 7 dargestellten Kristall 2. Es wird sodann über einen an sich bekannten Algorithmus entzerrt, so daß aus der Ellipse mit den Punkten $P_1$, $P_2$, $P_3$ ein Kreis mit korrespondierenden Punkten wird. Diese entzerrte Abbildung, die nicht einer konkreten optischen Darstellung entsprechen muß, sondern durch in einem Speicher abgelegte Daten realisiert wird, wird sodann dem weiteren Verfahren unterworfen.

Das eingelesene, entzerrte Bild wird sodann Zeile für Zeile nach den Punkten $P_1$ und $P_2$ durchsucht. Dabei wird mit der unteren Zeile begonnen, weshalb n = 1 gesetzt wird, wobei n die Zeilenzahl bedeutet. Werden in einer Zeile zwei Punkte gefunden, erfolgen die im Flußdiagramm dargestellten weiteren Prüfungen. Diese sind von besonderer Bedeutung für die Zuverlässigkeit der Durchmesserermittlung.

Es muß sichergestellt werden, daß die Punkte $P_1$ und $P_2$ vom Kristall, d. h. vom Meniskus stammen und nicht von Störquellen, z. B. von Reflexionen auf der Schmelze.

Sind alle Prüfungen mit positivem Ergebnis abgelegt, wird der ermittelte Wert in der Variablen $D_{max}$ gespeichert.

Im Anschluß an die Stelle "Ist Abstand zur unteren Kante > D/2" könnten deshalb im Flußdiagramm bei "ja" die Schlußfolgerung $D_{max} = D$ gezogen und die ermittelten Punkte $P_1$ und $P_2$ abgespeichert werden. Hierauf wird die nächste Zeile (n = n + 1) bearbeitet. Wird in dieser Zeile ein Wert für D gefunden, der größer ist als der bereits ermittelte Wert für $D_{max}$, dann wird der neue Wert für D als $D_{max}$ gespeichert. Dieses Verfahren wird Zeile für Zeile durchgeführt. Nachdem die letzte Zeile bearbeitet worden ist, sind $P_1$ und $P_2$ bekannt und der Abstand zwischen $P_1$ und $P_2$ steht in der Variablen $D_{max}$. In der Mitte zwischen $P_1$ und $P_2$ wird dann nach $P_3$ gesucht.

Als Abstand zur unteren Kante wird der Abstand der Verbindungslinie $P_1$ - $P_2$ zur unteren Bildkante bezeichnet. Die Bedingung, daß der Abstand Kleiner als D/2 ist, ist dann erfüllt, wenn der vordere Bereich des Meniskus-Kreises sichtbar ist. Dies wird hier vorausgesetzt.

Nachdem $P_3$, $P_M$, $\alpha$ und $\beta$ bestimmt wurden, werden die Meßpunkte I bis VIII (vgl. Fig. 7) auf dem Kreisbogen verteilt. Aus diesen Meßpunkten wird dann ein "Best Fit"-Kreis ermittelt, d. h. es wird eine Ausgleichskurve durch diese Punkte bestimmt.

In der Fig. 9 sind zwei Kameras 20, 21 und ein Kristall 2 in einer Ansicht von oben dargestellt. Die eine Kamera 20 hat hierbei eine große Brennweite und bildet den Hals 40 ab, der am Impfkristall 31 entstanden ist. Dagegen hat die Kamera 21 eine kleine Brennweite und bildet den gesamten Kristall 2 ab. Die Kamera 20 dient hierbei zur Wiedergabe der Situation beim Prozeßschritt gemäß Fig. 5b, während die Kamera 21 zur Wiedergabe der Situation bei den Prozeßschritten gemäß Fig. 5c, 5d vorgesehen ist.

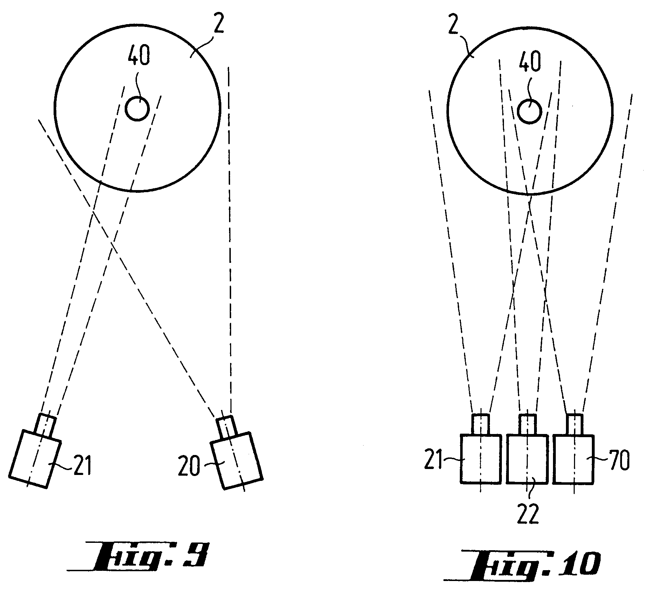

Die Fig. 10 zeigt den Einsatz von drei Kameras 21, 20, 70 in einer schematischen Ansicht von oben. Die Kameras 21, 70 haben beide kurze Brennweiten und bilden jeweils die Hälfte des Kristalls 2 ab. Ihr Einsatz wird während der Prozeßschritte gemäß Fig. 5c, 5d aktiviert. Die Kameras 21, 70 werden gleichzeitig ausgewertet, so daß sich der Vorteil der doppelten Auflösung ergibt. Die Kamera 22 hat eine lange Brennweite und dient zur Abbildung des Halses 40 während des Prozeßschrittes der Fig. 5b.

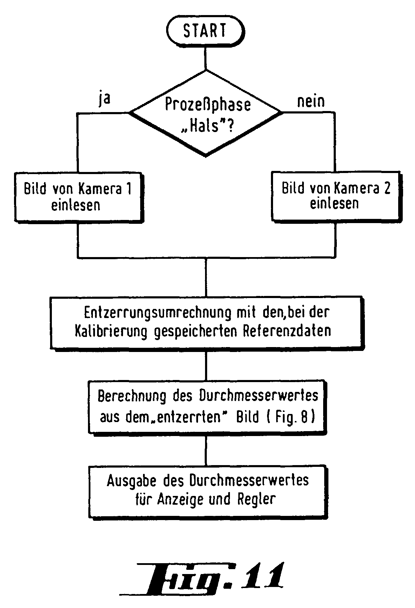

In der Fig. 11 ist ein Teil eines Flußdiagramms dargestellt, das für die Kamera-Konstellation gemäß Fig. 9 relevant ist. Es wird zunächst geprüft, ob die "Prozeßphase Hals" vorliegt. Ist dies nicht der Fall, wird die Kamera 21 aktiviert. Liegt dagegen die "Prozeßphase Hals" vor, wird Kamera 20 aktiviert. Die von den Kameras 20, 21 gelieferten Bilder werden sodann entzerrt, indem die bei der Kalibrierung gespeicherten Referenzdaten verwendet werden. Die entzerrten Daten müssen nicht optisch wiedergegeben werden; es genügt, wenn sie in einem Speicher abgelegt sind.

Die Berechnung des Durchmessers des Kristalls aus der entzerrten Darstellung des Kristalls 2 bzw. Halses 40 erfolgt dann gemäß den Vorschriften des Flußdiagramms nach Fig. 8.

Der ermittelte Durchmesserwert wird sodann angezeigt und einem Regler zugeführt.

Mit der Erfindung ist es somit möglich, eine genaue und störungsfreie Erfassung und Kontrolle des tatsächlichen und aktuellen Kristalldurchmessers in allen Phasen des Züchtungsprozesses durchzuführen, was eine wesentliche Voraussetzung für eine optimale Prozeßkontrolle und Kristallqualität bildet.

Die zwei oder mehr Kamerabilder werden auf besondere Weise ausgewertet, wodurch z. B. die Probleme eliminiert werden, die aufgrund sehr unterschiedlicher Lichtstärke- und Kontrastverhältnisse auftreten. So wird nicht nur die absolute Helligkeitsinformation von Schmelze, Meniskus und Kristall ausgewertet, sondern es werden auch zusätzlich die Intensitäts-Gradienten $\Delta J/\Delta X$ und $\Delta J/\Delta Y$ zur Auswertung herangezogen. Außerdem werden die geometrischen Verzerrungen korrigiert, die sich aufgrund der Lage und der Neigung der Bildebene und des Einblickwinkels einer Kamera ergeben. Hinzu kommt eine automatische Absolutwert-Eichung der Dimensionen für eine wählbare Bildebene mittels Standardschablone. Durch Gradienten-Bildung und -Auswertung werden die Kanten des Kristalls und des Meniskus-Rings sicher erkannt und definiert. Ein aktueller Kristalldurchmesser wird mittels eines speziellen und mehrstufigen Such- und Auswerte-Algorithmus - Auffinden von Kanten, Auffinden des maximalen Durchmessers, Relevanzkriterien, Festlegung von Meßlinien, Durchmesserermittelung mittels "Best Fit" aus vielen Meßpunkten etc. - bestimmt.

Um irrelevante Bildinhalte und Bildobjekte auszuschließen, werden verschiedene Relevanzkriterien herangezogen, z. B. durch prozeßabhängige Definition und Abfrage relevanter Symmetriebedingungen, durch Definition und Abfrage relevanter Intensitäts- und Kontrast- und Gradientenbedingungen, durch Definition und Abfrage sinnvoller oberer und unterer Grenzen für die Dimensionen des Meßobjekts und durch Vergleich mit abgespeicherten typischen Musterbildern.

Nach den vorstehenden Kriterien werden der Such- und Meßalgorithmus fortlaufend überprüft.

Die exakten Kristalldurchmesser können auf diese Weise auch bei eingeschränkten Lichtverhältnissen und bei nur teilweise sichtbarem oder auswertbarem Meniskus-Ring ermittelt werden. Hierbei ist es gleichgültig, ob eine Verdeckung aufgrund großer Bildwinkel bei großem Kristalldurchmesser oder aufgrund teilweiser Abdeckung bei wechselndem Durchmesser oder aufgrund einer teilweisen Abdeckung durch Einbauten in der Anlage erfolgt. Der "Vollkreis" des Kristalls wird in solchen Fällen auf rechnerische Weise ergänzt.

Ist der Meniskus-Ring nur teilweise verdeckt, erfolgt eine automatische Optimierung der Meßpunkt-Auswahl.

Weiterhin gestattet die Erfindung Anpassungen an die jeweiligen Prozeßbedingungen, u. a. durch Einstellen von Filterkonstanten, durch Einstellen von Geometrie-Bedingungen wie Symmetrie bzw. Kreisform, durch Einstellen von Intensitäts- und Gradientenbedingungen, durch Einstellen von Fenstergrößen und/oder durch Einstellen von unteren oder oberen Relevanzlimits für den Kristalldurchmesser.

In bestimmten Phasen des Kristallzieh-Prozesses, bei denen kein Meniskus auftritt, kann der Kristalldurchmesser trotzdem direkt gemessen werden.

**Patentansprüche**

1. Einrichtung für die Bestimmung von Durchmessern eines Kristalls, der aus einer Schmelze gezogen wird, mit m Kameras (20, 21) für die Abbildung von m Bereichen des Kristalls, wobei m $\geq$ 2, **dadurch gekennzeichnet**, daß die Bildwinkel ($\gamma$, $\delta$) der m Kameras (20, 21) den jeweils von ihnen abgebildeten Bereichen angepaßt sind.

2. Einrichtung nach Anspruch 1, **dadurch gekennzeichnet**, daß der abgebildete Bereich die ganze Bildebene einer Kamera wenigstens in einer Dimension ausfüllt.

3. Einrichtung nach Anspruch 1, **gekennzeichnet durch** eine erste Kamera (21), die den dünnen Hals des Kristalls abbildet.

4. Einrichtung nach Anspruch 1, **gekennzeichnet durch** eine zweite Kamera (20), die den zylindrischen Teil eines Kristalls abbildet.

5. Einrichtung nach Anspruch 1, **gekennzeichnet durch** eine dritte Kamera, die Bereiche mit unterschiedlichen Durchmessern abbildet und deren Bildwinkel an den größeren Durchmesser angepaßt ist.

6. Einrichtung nach Anspruch 1, **dadurch gekennzeichnet**, daß eine Kamera den Meniskus des Kristalls abbildet.

7. Einrichtung nach Anspruch 3, **dadurch gekennzeichnet**, daß eine Kamera einen Impfkristall (31) abbildet.

8. Einrichtung nach Anspruch 1, **dadurch gekennzeichnet**, daß die Längsache wenigstens einer der m Kameras senkrecht zur Längsachse des Kristalls (2) ausgerichtet ist.

9. Einrichtung nach den Ansprüchen 1 und 2, **dadurch gekennzeichnet**, daß die Längsachse wenigstens einer der m Kameras zur Längsachse des Kristalls einen Winkel $0° < \alpha < 90°$ bildet.

**10.** Einrichtung nach Anspruch 1, **dadurch gekennzeichnet**, daß verschiedene Kameras Teilbereiche eines und desselben Objekts abbilden.

**11.** Einrichtung nach Anspruch 10, **dadurch gekennzeichnet**, daß das Objekt der Hauptkörper (Body) des Kristalls (2) ist.

**12.** Einrichtung nach Anspruch 1, **dadurch gekennzeichnet**, daß die Längsachse einer ersten Kamera (20) gegenüber der Längsachse einer zweiten Kamera (21) um 180° versetzt angeordnet ist.

**13.** Einrichtung nach Anspruch 1 und Anspruch 12, **dadurch gekennzeichnet**, daß m Kameras (20, 21) nebeneinander angeordnet sind.

**14.** Einrichtung nach Anspruch 1, **dadurch gekennzeichnet**, daß eine automatische Kalibrierung für die Kameras (20, 21) vorgesehen ist.

**15.** Einrichtung nach Anspruch 1 und Anspruch 14, **dadurch gekennzeichnet**, daß für die Kalibrierung Elemente (27, 28) vorgesehen sind, die Teil eines Gehäuses (12, 13, 14) sind, welches einen Tiegel (7) umgibt, in dem sich die Schmelze (5) befindet.

**16.** Einrichtung nach Anspruch 1 und Anspruch 14, **dadurch gekennzeichnet**, daß eine Kalibrierungsplatte (41) vorgesehen und vorübergehend ein Tiegel (7) angeordnet ist.

**17.** Einrichtung nach Anspruch 16, **dadurch gekennzeichnet**, daß die Kalibrierungsplatte (41) an der voraussichtlichen Oberfläche der Schmelze (5) im Tiegel (7) positioniert ist.

**18.** Verfahren für die Bestimmung von Durchmessern eines Kristalls unter Verwendung von m Kameras (20, 21), **dadurch gekennzeichnet**, daß die Kameras (20, 21) zeitlich nacheinander, aber während des gleichen Prozesses verwendet werden.

**19.** Verfahren für die Bestimmung von Durchmessern eines Kristalls unter Verwendung von m Kameras (20, 21), **dadurch gekennzeichnet**, daß die Kameras zeitlich gleichzeitig während eines Prozesses verwendet werden.

**20.** Verfahren nach Anspruch 18, **dadurch gekennzeichnet**, daß die m Kameras verschiedene Positionen in der vertikalen Längsachse des Kristalls abbilden.

**21.** Verfahren nach Anspruch 19, **dadurch gekennzeichnet**, daß die m Kameras verschiedene Positionen horizontal zum Kristall abbilden.

**22.** Verfahren für die Bestimmung des Durchmessers eines Kristalls, der aus einer Schmelze gezogen wird, **dadurch gekennzeichnet**, daß die Auswerteschaltung folgende Schritte durchführt:

a) Entzerren des durch eine Schrägaufnahme des Kristalls entstandenen Bildes einer Kamera, so daß die in der Abbildung elliptische Form eines Kristall-Umfangs unter Berücksichtigung der Kalibrierung in einen Kreis überführt wird,
b) Abtasten des in einen Kreis überführten Umfangs auf seinen Durchmesser, wobei die beiden Eckpunkte, welche den Durchmesser markieren, erfaßt werden,
c) Suchen nach einem dritten Punkt auf dem Kreis,
d) Errechnen, ob die beiden Eckpunkte und der dritte Punkt auf einem gemeinsamen idealen Kreis liegen.

**23.** Verfahren für die Bestimmung des Durchmessers eines Kristalls, der aus einer Schmelze gezogen wird, **gekennzeichnet durch** folgende Schritte:

a) Abbilden des Meniskus mittels einer Kamera auf einer Bildebene;
b) Abtasten des Meniskus auf seinen Durchmesser, wobei die beiden äußeren Eckpunkte erfaßt werden;
c) Suchen nach dem untersten Punkt des Meniskus;
d) Errechnen einer Ellipse aufgrund der aufgefundenen Punkte;
e) Umrechnen der Ellipse in einen Kreis nach Maßgabe eines bekannten Algorithmus.

**24.** Verfahren nach Anspruch 1, Anspruch 22 und Anspruch 23, **dadurch gekennzeichnet**, daß die von zwei Kameras (20, 21) abgebildeten Gegenstände zeitlich nacheinander ausgewertet werden.

**25.** Verfahren nach den Ansprüchen 22 und 23, **dadurch gekennzeichnet**, daß Kanten des Kristalls oder des Meniskus-Rings durch Gradienten-Bildung und -Auswertung ermittelt werden.

**26.** Verfahren nach den Ansprüchen 22 bis 25, **dadurch gekennzeichnet**, daß Relevanzkriterien zum Ausschluß irrelevanter Bildinhalte und Bildobjekte verwendet werden.

**Fig. 1**

*Fig. 2*

*Fig. 3*

SPEICHER

BILDAUS-
WERTE-
EINHEIT

STEUERUNG

BEDIEN-
EINHEIT

*Fig. 4*

Fig. 5a

Fig. 5b

Fig. 5c

Fig. 5d

*Fig. 6*

Fig. 7

Fig. 8

Fig. 9

Fig. 10

START

ja          Prozeßphase          nein
            „Hals"?

Bild von Kamera 1          Bild von Kamera 2
einlesen                   einlesen

Entzerrungsumrechnung mit den,bei der
Kalibrierung gespeicherten Referenzdaten

Berechnung des Durchmesserwertes
aus dem„entzerrten" Bild ( Fig. 8 )

Ausgabe des Durchmesserwertes
für Anzeige und Regler

## Fig. 11